Europäisches Patentamt

European Patent Office

Office européen des brevets

(19)

(11) Numéro de publication: **0 216 425**
**B1**

(12) **FASCICULE DE BREVET EUROPEEN**

(45) Date de publication du fascicule du brevet:
06.06.90

(51) Int. Cl.⁵: **H01L 21/31**

(21) Numéro de dépôt: **86201608.6**

(22) Date de dépôt: **17.09.86**

(54) Procédé pour aplanir la surface d'un dispositif semiconducteur utilisant du nitrure de silicium comme materiau isolant.

(30) Priorité: **20.09.85 FR 8513987**

(43) Date de publication de la demande:
**01.04.87 Bulletin 87/14**

(45) Mention de la délivrance du brevet:
**06.06.90 Bulletin 90/23**

(84) Etats contractants désignés:
**DE FR GB IT NL**

(56) Documents cités:
**EP-A- 0 049 400**
**EP-A- 0 082 993**
**GB-A- 2 119 166**

**SOLID STATE TECHNOLOGY,**
**vol. 27, no. 5, mai 1984, pages 155-161, Port Washington,**
**New York, US; S.T. MASTROIANNI: "Multilevel**
**metallization device structures and process options"**

(73) Titulaire: **RTC-COMPELEC, 130, Avenue Ledru-Rollin,**
**F-75011 Paris(FR)**
(84) Etats contractants désignés: **FR**

(73) Titulaire: **N.V. Philips' Gloeilampenfabrieken,**
**Groenewoudseweg 1, NL-5621 BA Eindhoven(NL)**
(84) Etats contractants désignés: **DE GB IT NL**

(72) Inventeur: **Fabien, Raymond, Société Civile**
**S.P.I.D. 209, rue de l'Université, F-75007 Paris(FR)**
Inventeur: **DeCrouen, Jean-Michel, Société Civile**
**S.P.I.D. 209, rue de l'Université, F-75007 Paris(FR)**

(74) Mandataire: **Pinchon, Pierre et al, Société Civile**
**S.P.I.D. 209 rue de l'Université, F-75007 Paris(FR)**

## Description

La présente invention concerne un procédé pour aplanir la surface d'un dispositif semi-conducteur qui comporte un substrat portant en relief sur sa surface au moins une configuration de contact découpée dans une couche de contact, procédé consistant essentiellement à effectuer successivement:

a) un dépôt d'une couche de nitrure de silicium d'épaisseur sensiblement égale à celle de la couche de contact,

b) un dépôt d'une couche de laque d'épaisseur déterminée, suivi d'un traitement de ladite couche, la nature, l'épaisseur et le traitement de la couche de laque étant tels que la surface libre de cette couche soit sensiblement plane,

c) une attaque progressive, par plasma, de la couche de laque jusqu'à ce que les portions les plus proéminentes de la couche de nitrure de silicium soient complètement découvertes, de manière à reproduire une nouvelle surface libre dont la planéité est une image de celle de la surface libre de la laque, l'apparition complète des portions les plus proéminentes de la couche de nitrure étant détectée à l'aide d'un dispositif d'enregistrement des variations d'intensité d'une raie d'émission de l'azote,

d) une attaque simultanée, également par plasma, de la couche de nitrure de silicium et de la laque restante jusqu'à ce que la configuration de contact apparaisse complètement; un tel procédé est connu du brevet GB-A 2 119 166.

La technologie des semiconducteurs tend actuellement vers une intégration de plus en plus large d'un grand nombre de composants sur un même circuit monolithique. Cette évolution conduit à utiliser plusieurs niveaux superposés de configurations de contact afin de réduire l'encombrement en surface du semiconducteur et de pouvoir réaliser sur le même dispositif des fonctions de plus en plus nombreuses et complexes.

Il s'est avéré que, lorsque l'on veut établir un second niveau d'interconnexion, on se heurte à des difficultés provenant notamment du défaut de planéité de la surface du dispositif semiconducteur après que le premier niveau de configuration de contact ait été réalisé et recouvert d'une couche matériau isolant, du nitrure de silicium dans notre cas. Ceci est dû, en particulier, au fait que la surface du dispositif semiconducteur présente alors des reliefs dont l'épaisseur est égale à celle de la couche de contact.

Afin de pouvoir mettre en oeuvre cette technique d'interconnexion à plusieurs niveaux, il a été suggéré d'aplanir la surface des dispositifs semiconducteurs après avoir réalisé la configuration de contact de premier niveau. Conformément au procédé objet du préambule, il est connu d'effectuer un dépôt d'une couche de laque, par exemple une laque photosensible, présentant une surface libre pratiquement plane, dénuée de reliefs prononcés. La couche de laque est ensuite attaquée progressivement par un plasma, dans des conditions telles que la vitesse de décapage soit proche de la vitesse maximale, jusqu'à ce que les parties les plus proéminentes de la couche de nitrure de silicium aient complètement apparu. Cette étape est contrôlée à l'aide d'un dispositif d'enregistrement des variations d'intensité d'une raie de l'azote, selon une méthode de détection décrite, par exemple, dans l'article de W.R. Harshbarger et al. (J. of Electronic Materials, vol. 7, n°3, p.429, 1978). Enfin, le nitrure de silicium et la laque restante sont attaqués simultanément de façon que la configuration de contact soit complètement découverte.

Le but de la présente invention est de permettre une détection sûre du moment où la configuration de contact est complètement découverte. En effet, l'utilisation, sans précaution, du dispositif d'enregistrement des variations d'intensité d'une raie d'émission de l'azote peut, à cet égard, se révéler inefficace. C'est le cas notamment lorsque la couche de nitrure de silicium a une épaisseur sensiblement égale à celle de la configuration de contact et que la surface de substrat portant la configuration de contact est sensiblement égale à la surface de substrat non recouverte par la configuration de contact. Dans ces conditions, le moment où la configuration de contact est complètement découverte ne peut être mis en évidence puisqu'aucune variation sensible d'intensité de la raie d'émission de l'azote ne se produit, la quantité d'azote dégagé perdue lors de l'apparition de la configuration de contact étant compensée par la quantité d'azote dégagé gagnée en dehors de la configuration de contact.

Aussi, selon la présente invention, un procédé conforme au préambule est notamment remarquable en ce que, lors de ladite attaque simultanée de la couche de nitrure de silicium et de la laque restante, les conditions de l'attaque sont choisies telles que la vitesse d'attaque de la laque soit supérieure à la vitesse d'attaque du nitrure de silicium de façon à éliminer complètement la laque avant apparition de la configuration de contact, ceci afin de détecter avec une sensibilité accrue, à l'aide dudit dispositif d'enregistrement, l'apparition complète de la configuration de contact.

Ainsi, la laque étant décapée plus rapidement que le nitrure de silicium, il se produit un moment où le nitrure affleure sur toute la surface du dispositif semiconducteur, d'où une augmentation sensible de l'intensité de la raie d'émission considérée de l'azote. Puis quand la configuration de contact apparaît cette intensité diminue pour ensuite se stabiliser quand la configuration de contact est complètement découverte. On dispose alors d'un moyen plus sûr et plus sensible pour détecter la mise à nu de la configuration de contact.

La description qui va suivre en regard des dessins annexés, donnés à titre d'exemples non limitatifs, fera bien comprendre en quoi consiste l'invention et comment elle peut être réalisée.

Les figures 1 à 4 montrent schématiquement en coupe les différentes phases de réalisation d'un dispositif semiconducteur obtenu selon le procédé conforme à l'invention.

La figure 5 donne les variations de l'intensité I

d'une raie d'émission de l'azote au cours des différentes étapes du procédé selon l'invention.

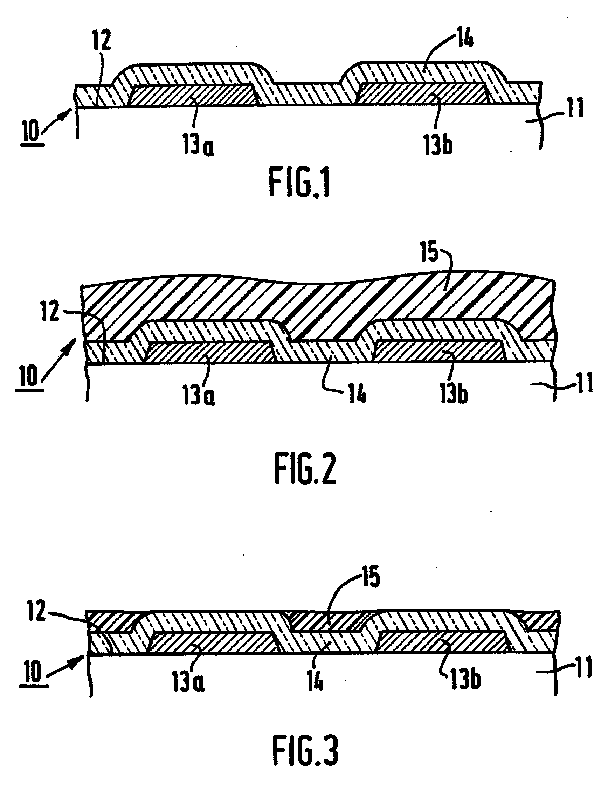

Les figures 1 à 4 représentent les différentes étapes d'un procédé pour aplanir la surface d'un dispositif semiconducteur 10 qui comporte un substrat 11 en matériau semiconducteur, du silicium par exemple, portant sur sa surface 12 une configuration de contact 13a, 13b découpée dans une couche de contact qui peut être une couche d'aluminium de 800 nm d'épaisseur.

Comme le montre la figure 1, on dépose sur le substrat 11 et la configuration de contact 13a, 13b, une couche 14 de nitrure de silicium SiN d'une épaisseur sensiblement égale à celle de la couche de contact.

Un tel dépôt peut être opéré par formation d'un plasma à partir du silane $SiH_4$ et d'azote $N_2$. A ce stade du procédé, le relief présenté par la couche 14 du nitrure de silicium reproduit sensiblement le relief de la configuration de contact. Le nitrure n'intervient donc pas directement dans le procédé d'aplanissement mais surtout comme isolant électrique entre les éléments de la configuration de contact.

On dépose ensuite sur l'ensemble du dispositif une couche de laque 15 sur une épaisseur d'environ 1600 nm, soit le double de l'épaisseur de la couche de contact. Ladite laque peut être une laque photosensible, par exemple celle connue sous la référence HPR 204 et commercialisée par la Société HUNT Chemical. Le dépôt de laque est, de préférence, effectuée par double pelliculage puis exposition de l'ensemble à la lumière UV pendant 45s et cuisson à 200°C pendant 30 min. La laque ainsi traitée permet d'atténuer de façon très sensible les reliefs de la surface du dispositif, ainsi que le montre la figure 2.

On attaque ensuite, de façon progressive, la couche de laque 15 par un plasma constitué, par exemple, d'un mélange gazeux d'hexafluoroéthane $C_2F_6$ et d'oxygène $O_2$. Durant cette étape, les conditions sont choisies de telle sorte que la vitesse d'attaque de la laque soit proche de la vitesse maximale. Une vitesse d'attaque de 50 à 80 nm/min est obtenue en utilisant un mélange gazeux de 75% de $O_2$ et 25% de $CF_4$ sous une pression de l'ordre de 0,4 millibar et activé par un champ électrique radiofréquence de 380 kHz. Ces conditions d'attaque sont maintenues jusqu'à ce que les portions les plus proéminentes de la couche 14 de nitrure apparaissent. A ce moment, le procédé en est au stade de la figure 3 où la surface libre du dispositif semiconducteur reproduit dans une large mesure la surface libre initiale de la laque.

L'apparition des parties les plus proéminentes de la couche de nitrure est détectée à l'aide d'un dispositif d'enregistrement des variations d'intensité d'une raie d'émission de l'azote. Ce mode de détection bien connu consiste, d'une façon générale, à suivre les variations de l'intensité d'une raie d'émission choisie dans le spectre de l'espèce dont on veut connaître l'évolution de la concentration dans le plasma. Les spectres d'émission sont connus des ouvrages spécialisés dans la spectroscopie, mais le choix de la raie dépend beaucoup du milieu réactionnel. Dans notre cas, la connaissance du spectre de l'azote ne donne rien si l'on ne connaît pas le spectre établi dans les conditions de gravure. La règle est de déterminer expérimentalement quelle est la raie la moins perturbée par la présence d'autres raies et la plus sensible à la variation de concentration. Le choix était possible entre deux groupes de raies de l'azote :

- 1 groupe de 2 raies entre 845 et 875 nm
- 1 groupe de 3 raies entre 740 et 785 nm c'est finalement la raie à 783 nm qui s'est révélée la plus sensible.

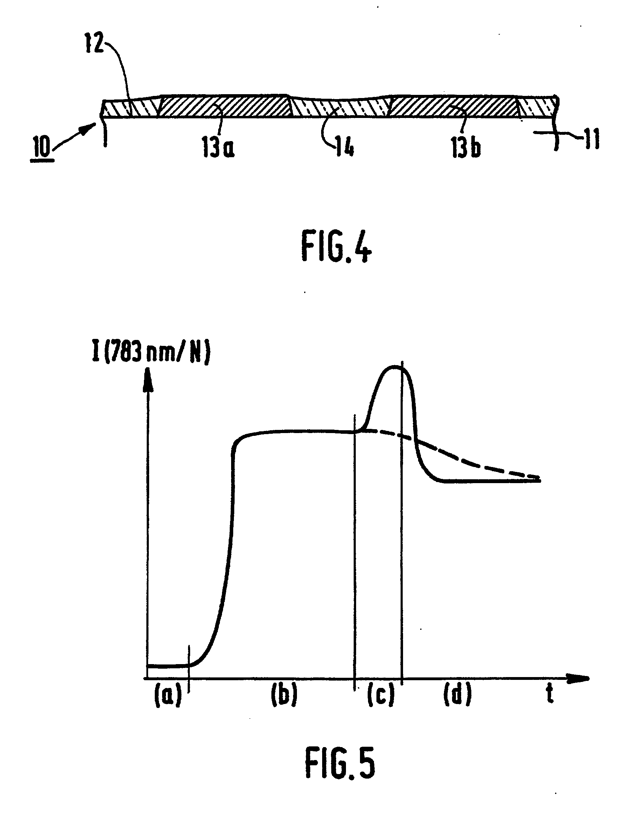

Ainsi, en début de procédé, au cours de l'attaque de la laque seule, la concentration en azote est négligeable et l'intensité de la raie d'émission correspondante est quasi nulle. Puis, cette intensité croit lorsque les parties les plus proéminentes de la couche de nitrure apparaissent, pour ensuite se stabiliser lorsque le nitrure affleure totalement. Ces deux premières étapes sont représentées par les parties (a) et (b) du diagramme de la figure 5.

A partir de la situation représentée à la figure 3, on procède à une attaque simultanée, également par plasma, de la couche 14 de nitrure de silicium et de la laque restante jusqu'à ce que la configuration 13a, 13b de contact apparaisse complètement. Il importe donc de pouvoir déterminer avec précision le moment où la configuration de contact est totalement découverte. Si aucune précaution particulière n'est prise, il peut se produire que ce moment soit assez difficile à détecter, surtout lorsque l'épaisseur de la couche 14 de nitrure est égale à celle de la couche de contact et lorsque les surfaces de la configuration de contact et du substrat nu sont équivalentes. Il se produit alors une compensation entre l'apparition du nitrure de silicium sous la laque restante et la disparition de nitrure quand la configuration de contact est découverte. On obtient dans ce cas une courbe de variation d'intensité de la raie d'émission de l'azote de type de celle représentée en pointillé à la figure 5. Il est donc préférable de prévoir des moyens qui permettent de marquer plus nettement la mise à découvert complète de la configuration de contact 13a, 13b. C'est pourquoi, lors de l'attaque simultanée de la couche 14 de nitrure et de la laque restante, on accélère la vitesse d'attaque de laque en augmentant la teneur en oxygène du plasma. Ainsi la laque est complètement décapée avant que la configuration de contact soit découverte. Il en résulte, comme le montre la figure 5, une augmentation de l'intensité de la raie d'émission de l'azote (Zone (c)), suivie d'une diminution correspondant à la mise à nu de la configuration de contact, puis l'intensité de la raie d'émission de l'azote se stabilise (Zone (d)) lorsque la configuration de contact est complètement découverte. L'accélération de la vitesse d'érosion de la laque peut se faire dès le début de l'attaque simultanée du nitrure et de la laque restante, avec l'inconvénient de créer un défaut de planéité final, ou encore en fin d'attaque de la laque restante, ce qui est plus difficile à contrôler.

Le procédé décrit pour aplanir la surface d'un dispositif semiconducteur est arrêté dès que l'intensité de la raie d'émission considérée a atteint une valeur constante (figure 5). On peut alors réaliser, si on le désire, un deuxième niveau de configuration de contact.

L'invention ne saurait être limitée à l'exemple décrit mettant en oeuvre un mélange d'hexafluoroéthane et d'oxygène, d'autres composés peuvent en effet convenir comme l'hexafluoroéthane $C_2F_6$, le trifluorométhane $CHF_3$ ou l'hexafluorure de soufre $SF_6$. De même, l'oxygène peut être remplacé en tout ou partie par un composé d'oxygène comme le protoxyde d'azote NO.

Un avantage important du procédé selon l'invention réside dans le fait qu'il procure une couche de matériau isolant dont l'épaisseur finale est uniforme.

Il est alors possible de graver ensuite des ouvertures dans cette couche au moyens d'une seule opération de photomasquage. Au contraire, selon les procédés connus, il est le plus souvent nécessaire d'effectuer ces ouvertures au moyen de deux opérations de photomasquage l'une étant réservée à des ouvertures de petites dimensions à l'aplomb de portions étroites de la configuration de contact, et l'autre réservée à des ouvertures plus larges, à l'aplomb de portions de grande étendue de ladite configuration, les épaisseurs respectives de couche isolante obtenues selon ces procédés connus étant trop différentes.

Il est clair que cette simplification du processus d'élaboration revêt un avantage économique important.

## Revendications

1. Procédé pour aplanir la surface d'un dispositif semiconducteur qui comporte un substrat portant en relief sur sa surface au moins une configuration de contact découpée dans une couche de contact, procédé consistant essentiellement à effectuer successivement :

a) un dépôt d'une couche de nitrure de silicium d'épaisseur sensiblement égale à celle de la couche de contact,

b) un dépôt d'une couche de laque d'épaisseur déterminée, suivi d'un traitement de ladite couche, la nature, l'épaisseur et le traitement de la couche de laque étant tels que la surface libre de cette couche soit sensiblement plane,

c) une attaque progressive, par plasma, de la couche de laque jusqu'à ce que les portions les plus proéminentes de la couche de nitrure de silicium soient complètement découvertes, de manière à reproduire une nouvelle surface libre dont la planéité est une image de celle de la surface libre de la laque, l'apparition complète des portions les plus proéminentes de la couche de nitrure étant détectée à l'aide d'un dispositif d'enregistrement des variations d'intensité d'une raie d'émission de l'azote,

d) une attaque simultanée, également par plasma, de la couche de nitrure de silicium et de la laque restante jusqu'à ce que la configuration de contact apparaisse complètement, caractérisé en ce que, lors de ladite attaque simultanée de la couche de nitrure de silicium et de la laque restante, les conditions de l'attaque sont choisies telles que la vitesse d'attaque de la laque soit supérieure à la vitesse d'attaque du nitrure de silicium de façon à éliminer complètement la laque avant apparition de la configuration de contact, ceci afin de détecter avec une sensibilité accrue à l'aide dudit dispositif d'enregistrement, l'apparition complète de la configuration de contact.

2. Procédé selon la revendication 1, caractérisé en ce que, le plasma étant formé d'un mélange gazeux contenant un composé de fluor et de l'oxygène ou un composé de l'oxygène, la vitesse d'attaque de la laque est rendue supérieure à la vitesse d'attaque du nitrure de silicium en augmentant la proportion d'oxygène ou du composé d'oxygène dans le mélange gazeux.

## Claims

1. A method of planarizing the surface of a semiconductor device comprising a substrate carrying in relief on its surface at least one contact configuration cut out of a contact layer, which method consists essentially in that the following steps are successively carried out:

(a) depositing a silicon nitride layer having a thickness substantially equal to that of the contact layer,

(b) depositing a lacquer layer having a given thickness and then treating the said layer, the nature, the thickness and the treatment of the lacquer layer being such that the free surface of this layer is substantially flat,

(c) progressively attacking by plasma the lacquer layer until the farthest projecting parts of the silicon nitride layer are completely exposed in order that a new free surface is reproduced, whose flatness is an image of that of the free surface of the lacquer layer, the complete appearance of the farthest projecting parts of the nitride layer being detected by means of a device for recording the intensity variations of an emitted jet of nitrogen,

(d) attacking simultaneously, also by plasma, the silicon nitride layer and the remaining lacquer until the contact configuration appears completely, characterized in that during the said step of simultaneously attacking the silicon nitride layer and the remaining lacquer, the conditions of attack are chosen so that the rate of attack of the lacquer is higher than the rate of attack of the silicon nitride so that the lacquer is completely removed before the appearance of the contact configuration, in order to detect with increased sensitivity by means of the said recording device the complete appearance of the contact configuration.

2. A method as claimed in Claim 1, characterized in that the plasma being formed from a gaseous mixture containing a compound of fluorine and oxygen or a compound of oxygen, the rate of attack of the lacquer is made higher than the rate of attack of the silicon nitride by increasing the quantity of oxygen or of the oxygen compound in the gaseous mixture.

## Patentansprüche

1. Verfahren zum Ebnen der Oberfläche einer Halbleiteranordnung mit einem Substrat, das in Relief an der Oberfläche mindestens eine in einer Kontaktschicht ausgeschnittene Kontaktkonfiguration aufweist, wobei dieses Verfahren im wesentlichen aus der Durchführung der nachfolgenden Verfahrensschritte besteht:

a) das Niederschlagen einer Siliziumnitridschicht mit einer Dicke, die der der Kontaktschicht nahezu entspricht,

b) das Niederschlagen einer Lackschicht mit einer bestimmten Dicke, wonach diese Schicht behandelt wird, wobei die Art, die Dicke und die Behandlung der Lackschicht derart ist, daß die freie Oberfläche dieser Schicht nahezu flach wird,

c) das progressive Plasma-Ätzen der Lackschicht, bis die am meisten vorspringenden Teile der Siliziumnitridschicht völlig freigelegt sind, so daß eine neue freie Oberfläche erhalten wird, deren Flachheit ein Bild der Flachheit der freien Oberfläche des Lackes ist, wobei die vollständige Erscheinung der am meisten vorspringenden Teile der Nitridschicht mit Hilfe einer Anordnung zum Aufzeichnen der Intensitätsschwankungen eines Stickstoffemissionstrahles detektiert wird,

d) das gleichzeitige Ätzen, ebenfalls mit Plasma, der Siliziumnitridschicht und des restlichen Lackes, bis die Kontaktkonfiguration vollständig erscheint, dadurch gekennzeichnet, daß während des Verfahrensschrittes der gleichzeitigen Ätzung der Siliziumnitridschicht und des restlichen Lacks die Umstände der Ätzung derart gewählt worden sind, daß die Ätzgeschwindigkeit des Lackes höher ist als die Ätzgeschwindigkeit des Siliziumnitrids, so daß der Lack vor dem Erscheinen der Kontaktkonfiguration völlig entfernt ist, damit mit einer erhöhten Empfindlichkeit mit Hilfe der genannen Aufzeichnungsanordnung das vollständige Erscheinen der Kontaktkonfiguration detektiert werden kann.

2. Verfahren nach Anspruch 1, dadurch gekennzeichnet, daß das Plasma aus einem Gasgemisch mit einer Verbindung von Fluor und Sauerstoff oder einer Verbindung von Sauerstoff gebildet ist, wobei die Ätzgeschwindigkeit des Lackes dadurch höher gemacht worden ist als die Ätzgeschwindigkeit des Siliziumnitrides, daß die Sauerstoffmenge oder die Menge der Sauerstoffverbindung in dem Gasgemisch vergrößert ist.

FIG.1

FIG.2

FIG.3

FIG.4

FIG.5